# EUROPEAN PATENT APPLICATION

(11) **EP 4 391 026 A1**
(43) Date of publication of application: **26.06.2024**
(21) Application number: 21952108.5
(22) Date of filing: 19.08.2021
(51) Int. Cl.: H01L 21/3205, H01L 21/768, H01L 23/532

(54) **ELECTROCONDUCTIVE MEMBER, ELECTRONIC DEVICE, AND METHOD FOR MANUFACTURING ELECTROCONDUCTIVE MEMBER**

(71) Applicant: Kabushiki Kaisha Toshiba, Tokyo 105-0023 (JP)
(72) Inventor: SHIDA, Naomi, Tokyo 1050023 (JP); NAITO, Katsuyuki, Kawasaki-shi Kanagawa 2100024 (JP); MIZUGUCHI, Koji, Tokyo 1050023 (JP); SAITA, Yutaka, Kawasaki-shi Kanagawa 2120013 (JP)
(74) Representative: Hoffmann Eitle
(86) International application number: PCT/JP2021/030338
(87) International publication number: WO 2023/021648

(57) **Abstract**

A conductive member, an electronic device, and a method for manufacturing the conductive member, in which stable characteristics can be obtained are provided. According to one embodiment of the invention, a conductive member includes a first layer including a metal nanowire, a second layer including a polythiophene member, and a third layer including a graphene member including a graphene skeleton. The second layer is provided between the metal nanowire and the third layer.

## Description

### [Technical Field]

Embodiments of the invention relate to a conductive member, an electronic device, and a method for manufacturing the conductive member.

### [Background Art]

A conductive member including graphene is used as an electrode. Stable properties are desired in conductive members.

### [Prior Art Document]

### [Patent Document]

[Patent Document 1] International Publication 2020/178974

### [Summary of Invention]

### [Problem to be Solved by Invention]

The embodiments provide a conductive member, an electronic device, and a method for manufacturing the conductive member, in which stable characteristics can be obtained.

### [Means for Solving Problem]

According to one embodiment of the invention, a conductive member includes a first layer including a metal nanowire, a second layer including a polythiophene member, and a third layer including a graphene member including a graphene skeleton. The second layer is provided between the metal nanowire and the third layer.

### [Brief Description of Drawings]

[FIG. 1]

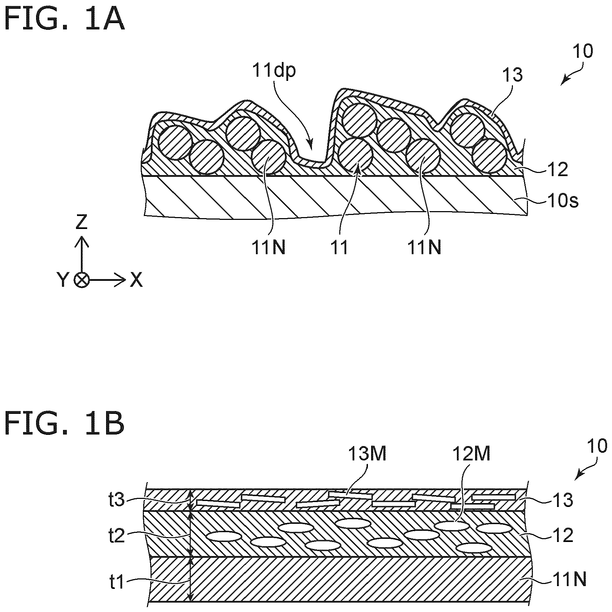

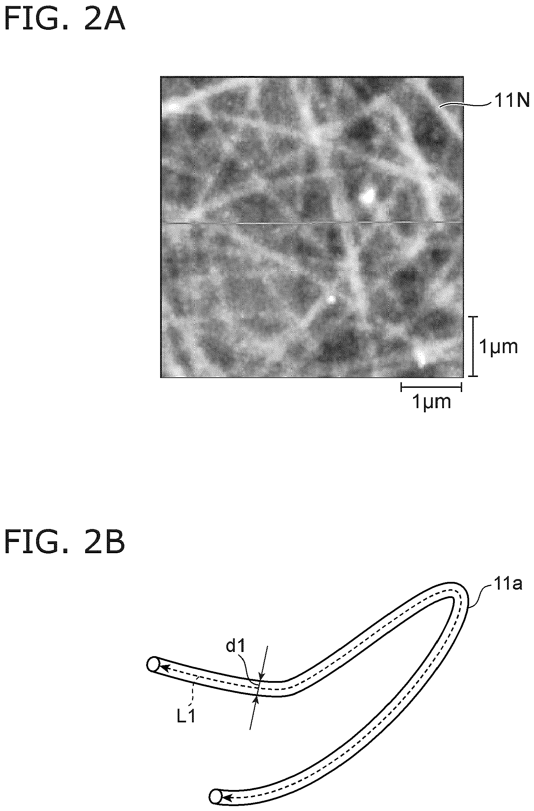

   FIGS. 1A and 2B are schematic cross-sectional views illustrating a conductive member according to a first embodiment.
[FIG. 2]
   FIGS. 2A and 2B are schematic views illustrating a part of the conductive member according to the first embodiment.
[FIG. 3]

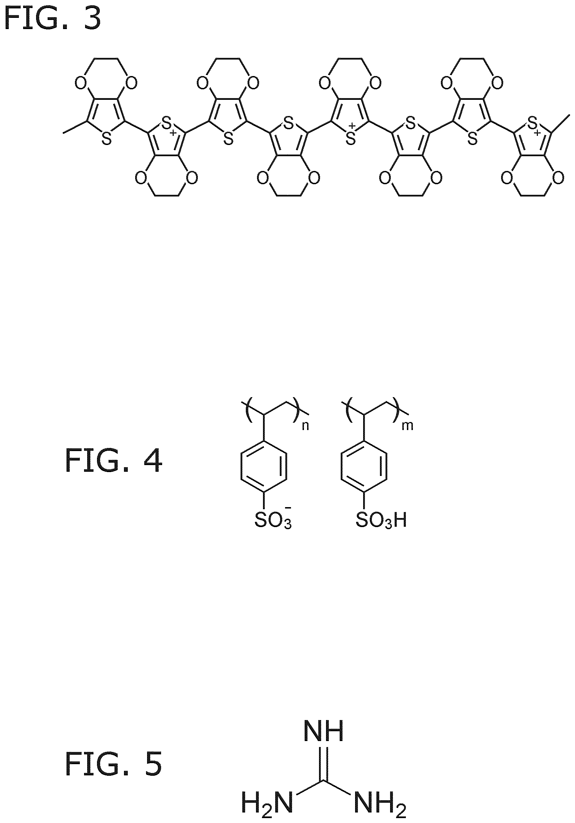

   FIG. 3 is a schematic view illustrating a material of a part of the conductive member according to the first embodiment.
[FIG. 4]
   FIG. 4 is a schematic view illustrating a material of a part of the conductive member according to the first embodiment.
[FIG. 5]
   FIG. 5 is a schematic view illustrating a material of a part of the conductive member according to the first embodiment.
[FIG. 6]

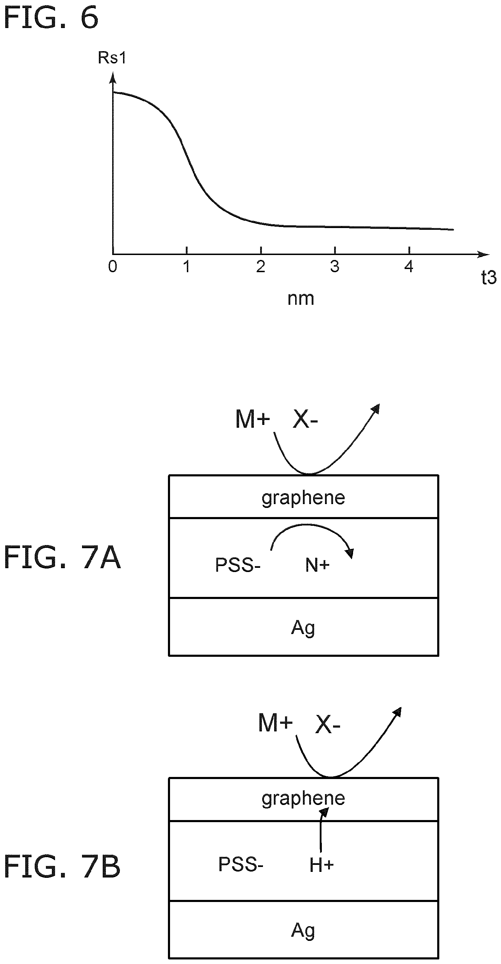

   FIG. 6 is a graph illustrating characteristics of the conductive member.
[FIG. 7]
   FIGS. 7A and 7B are schematic views illustrating the conductive member.
[FIG. 8]

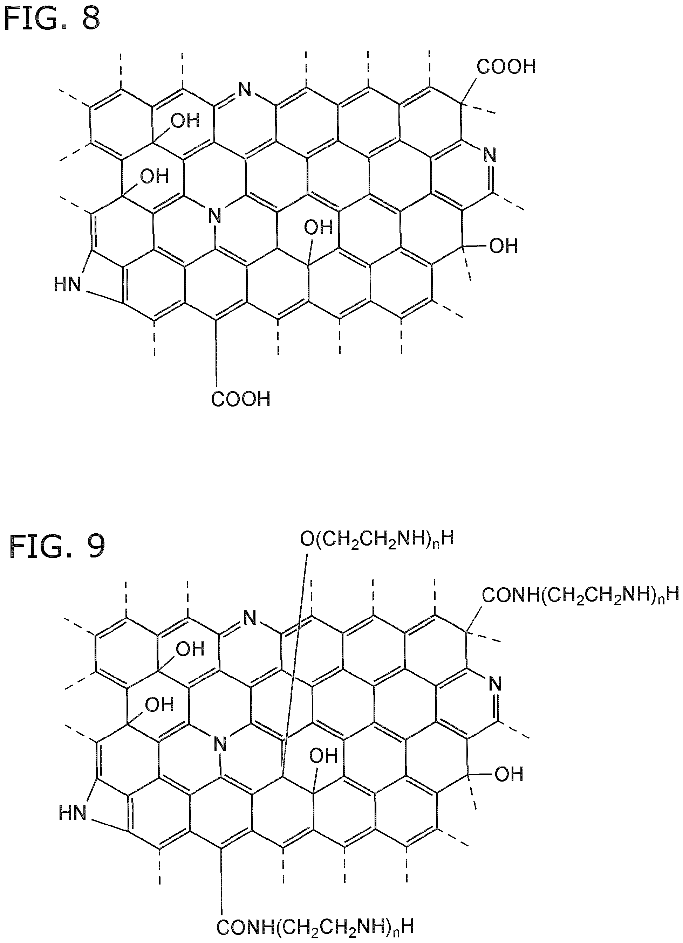

   FIG. 8 is a schematic view illustrating a part of the conductive member according to the first embodiment.
[FIG. 9]
   FIG. 9 is a schematic view illustrating a part of the conductive member according to the first embodiment.
[FIG. 10]

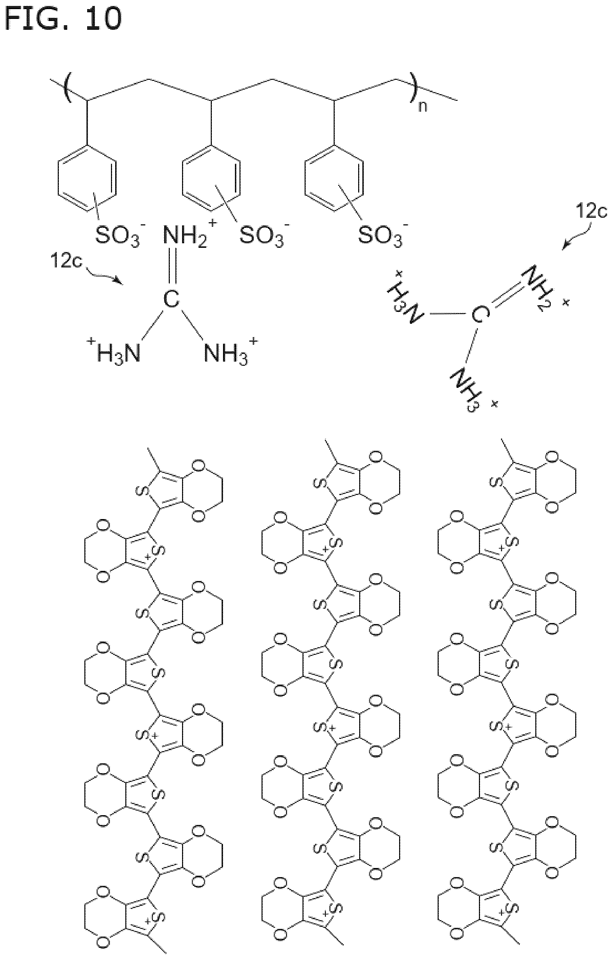

   FIG. 10 is a schematic view illustrating a part of the conductive member according to the first embodiment.
[FIG. 11]

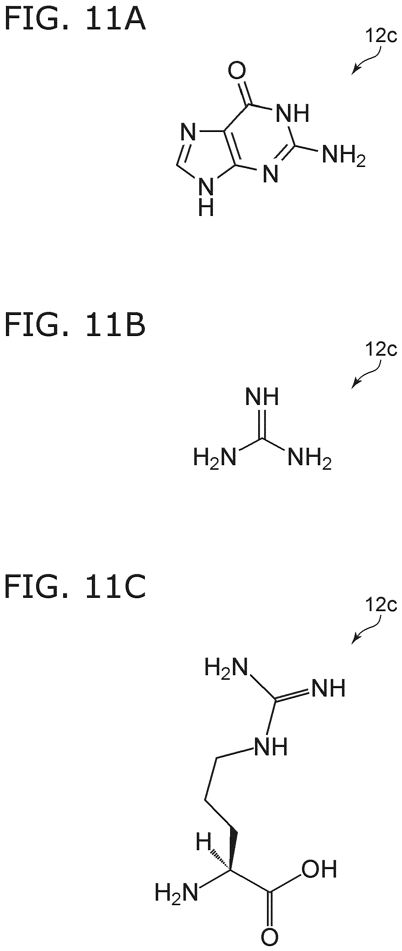

   FIGS. 11A to 11C are schematic views illustrating a part of the conductive member according to the first embodiment.
[FIG. 12]

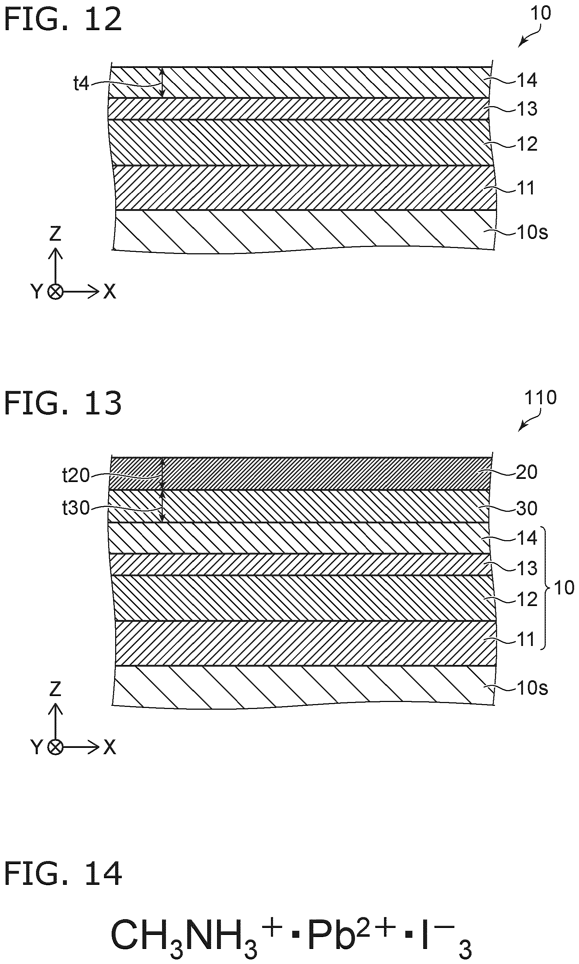

   FIG. 12 is a schematic cross-sectional view illustrating the conductive member according to the first embodiment.
[FIG. 13]
   FIG. 13 is a schematic cross-sectional view illustrating an electronic device according to a second embodiment.
[FIG. 14]
   FIG. 14 is a schematic cross-sectional view illustrating the electronic device according to the second embodiment.
[FIG. 15]

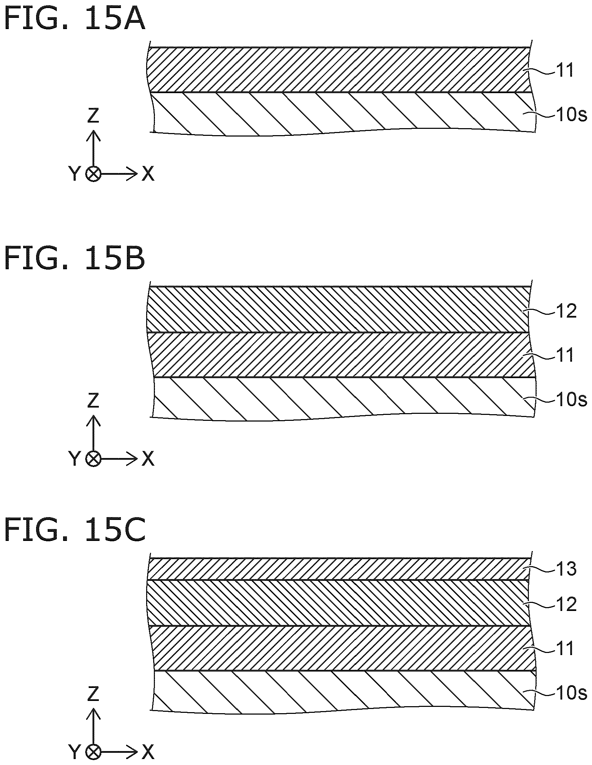

   FIGS. 15A to 15C are schematic cross-sectional views illustrating a method for manufacturing a conductive member according to a third embodiment.

### [Embodiments of Invention]

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### (First embodiment)

FIGS. 1A and 2B are schematic cross-sectional views illustrating a conductive member according to a first embodiment.

FIG. 1B is an enlarged view of a part of FIG. 1A. As shown in FIG. 1A, a conductive member 10 according to the embodiment includes a first layer 11, a second layer 12, and a third layer 13. The first layer 11 includes metal nanowires 11N. A second layer 12 is provided between the metal nanowires 11N and the third layer 13. As shown in FIG. 1B, the second layer 12 includes a polythiophene member 12M. As shown in FIG. 1B, the third layer 13 includes a graphene member 13M. The graphene member 13M includes a graphene skeleton.

The first layer 11 is, for example, a metal nanowire layer. The first layer 11 has a stacked structure in which the metal nanowires 11N are intertwined. The first layer 11 includes openings. An unevenness lldp is large on the surface of the first layer 11. The second layer 12 and the third layer 13 cover the first layer 11 along the unevenness lldp of the first layer 11, for example.

The conductive member 10 may be provided on a base 10s. The base 10s extends along an X-Y plane. A direction perpendicular to the X-Y plane is defined as a Z-axis direction. For example, the first layer 11 is provided on the base 10s. The second layer 12 is provided on the first layer 11. The third layer 13 is provided on the second layer 12. There is the first layer 11 between the base 10s and the third layer 13. The base 10s may be optically transparent, for example. The base 10s may include, for example, an organic material. The base 10s may include, for example, PET (polyethylene terephthalate) or the like. The base 10s may include, for example, glass or the like.

The conductive member 10 is, for example, light transmissive. The conductive member 10 is, for example, a light transmissive electrode. The conductive member 10 may be, for example, a transparent electrode.

In the embodiment, the first layer 11 includes metal nanowires 11N. The metal nanowires 11N includes, for example, silver. The metal nanowires 11N may be silver nanowires, for example. The metal nanowires 11N may include, for example, an alloy including silver. The metal nanowires 11N may include, for example, silver and a first metal element. The first metal element includes, for example, at least one selected from the group consisting of Pd, Pt, Au, Zn and Cu.

Since the first layer 11 includes the metal nanowires 11N, the first layer 11 has high light transmittance and high electrical conductivity. The provision of the second layer 12 further improves the stability of the first layer 11.

As shown in FIG. 1B, at least a part of the second layer 12 is provided between the metal nanowires 11N and the third layer 13.

As shown in FIG. 1A, the first layer 11 includes multiple metal nanowires 11N. At least two of the multiple metal nanowires 11N are intertwined (see FIG. 2A). The first layer 11 has unevenness lldp due to the multiple metal nanowires 11N. The second layer 12 and the third layer 13 are along the unevenness lldp. At least a part of the second layer 12 and at least a part of the third layer 13 are between two of the multiple metal nanowires 11N.

FIGS. 2A and 2B are schematic views illustrating a part of the conductive member according to the first embodiment.

The metal nanowires 11N included in the first layer 11 are illustrated. FIG. 2A is an AFM (Atomic Force Microscope) image of the first layer 11 including the metal nanowires 11N.

As shown in FIG. 2A, the first layer 11 includes the multiple metal nanowires 11N. The metal nanowires 11N and the space between the multiple metal nanowires 11N are substantially covered with the second layer 12 (for example, polythiophene layer). FIG. 2B illustrates one metal nanowire 11N.

A diameter d1 of the metal nanowire 11N is, for example, not less than 10 nm and not more than 150 nm.

If the diameter d1 of the metal nanowires 11N is too small, an electrical resistance of the metal nanowires 11N increases. When the diameter d1 is excessively large, the dispersed state of the multiple metal nanowires 11N tends to become unstable. If the diameter d1 is excessively large, light scattering or the like by the multiple metal nanowires 11N increases, and transparency tends to decrease. More preferably, the diameter d1 of the metal nanowires 11N is, for example, not less than 20 nm and not more than 120 nm. More preferably, the diameter d1 is not less than 30 nm and not more than 100 nm.

A length L1 of the metal nanowires 11N is, for example, not less than .1 µm and not more than 50 µm. If the length L1 of the metal nanowires 11N is too short, sufficient conductive clusters may not be formed, resulting in a high electrical resistance. If the length L1 of the metal nanowires 11N is excessively long, the dispersion of the multiple metal nanowires 11N in the solvent tends to become unstable when manufacturing the conductive member 10 (electrode or the like). The length L1 is preferably not less than 1 µm and not more than 40 µm. More preferably, the length L1 is not less than 5 µm and not more than 30 µm. The length L1 may be a length along the extending direction of the bent metal nanowires 11N. For example, the length L1 may be a sum of the lengths of multiple portions extending in different directions included in the bent metal nanowire 11N.

The surface density of the multiple metal nanowires 11N is, for example, not less than 0.05 g/m² and not more than 50 g/m². When the surface density of the multiple metal nanowires 11N is within this range, it is easy to obtain high light transmittance, high flexibility, and high electrical conductivity in the conductive member 10 (electrode or the like). The surface density is preferably, for example, not less than 0.1 g/m² and not more than 10 g/m². More preferably, the surface density is, for example, not less than 0.15 g/m² and not more than 10 g/m².

In the embodiment, for example, the third layer 13 including the graphene member 13M is provided on the second layer 12. It has been found that this makes the characteristics of the conductive member 10 more stable.

Examples of experimental results conducted by the inventors of the present application will be described below.

FIGS. 3 to 5 are schematic views illustrating a part of the conductive member according to the first embodiment.

In the experiment, the following samples are made. In a first sample, the first layer 11 is formed on the base 10s, and the second layer 12 is formed thereon. In the first sample, no third layer 13 is formed. In a second sample, the first layer 11 is formed on the base 10s, the third layer 13 is formed thereon, and the second layer 12 is formed thereon. In a third sample, the first layer 11 is formed on the base 10s, the second layer 12 is formed thereon, and the third layer 13 is formed thereon. The positions of the second layer 12 and the third layer 13 are reversed between the second sample and the third sample.

In these samples, the base 10s is a PET substrate. The first layer 11 includes Ag nanowires. The thickness of the first layer 11 is approximately 50 nm. The thickness of the first layer 11 depends, for example, on the diameter d1 of the metal nanowires 11N. The thickness of the first layer 11 corresponds to the thickness of the overlapping portion of the metal nanowires 11N. The second layer 12 includes PEDOT (poly (3,4-ethylenedioxythiophene)) (see FIG. 3), PSS (poly (4-styrenesulfonic acid)) (see FIG. 4), and guanidine (see FIG. 5). FIG. 3 shows that a part of the PEDOT is oxidized and doped with holes. FIG. 4 shows a partially ionized state of PSS. In FIG. 5, guanidine is in the neutral state. The thickness of the second layer 12 is approximately 20 nm. The third layer 13 is N-graphene. The thickness of the third layer 13 is approximately 2 nm.

The first layer 11 is formed by coating. In experiments, a substrate of PET is UV-ozone treated. The surface of the substrate becomes hydrophilic. A coating device includes a coating bar and a stage. The cross-sectional shape of the application bar is circular. A substrate is placed on the stage. The distance between the coating bar and the substrate is set to 500 µm. An aqueous dispersion (first liquid) is prepared from multiple silver nanowires. A first liquid is dropped onto the coating bar. A meniscus of the first liquid is formed between the substrate and the coating bar. A film of the first liquid is formed on the substrate by relatively moving the coating bar and the substrate. The speed of relative movement is 5 m/min. The substrate is heated to 100° C on a hot plate. As a result, the film formed on the substrate by the first liquid is dried. Thereby, the first layer 11 is obtained.

The second layer 12 is formed by coating. PEDOT (poly (3,4-ethylenedioxythiophene)), PSS (poly (4-styrenesulfonic acid)) and guanidine are dispersed in water to obtain a coating liquid (second liquid). The pH of the second liquid is, about 6. The second liquid is dropped onto the coating bar to form a meniscus of the second liquid between the substrate and the coating bar. A film of second liquid is formed on the first layer 11. The speed of relative movement is 5 m/min. The second layer 12 is obtained from the film of the second liquid by drying at 100 °C on a hot plate.

The third layer 13 is formed by coating. A coating liquid (third liquid) is obtained by dispersing N-graphene to which polyethyleneimine chains are bonded in ethanol. The third liquid is dropped onto the coating bar to form a meniscus of the third liquid between the substrate and the coating bar. A film of the third liquid is formed on the second layer 12 by relatively moving the coating bar and the substrate. The speed of relative movement is 3 m/min. The third layer 13 is obtained from the film of the third liquid by drying at 80 °C on a hot plate.

The initial sheet resistance of each of these samples is about 10Ω/square. The sheet resistance is measured after contacting the surfaces of these samples with MAI (methylammonium iodide) as an impurity.

The sheet resistance after contacting MAI (after testing) is as follows. The sheet resistance after testing in the first sample is 550Q/square. The sheet resistance after testing in the second sample is 500Ω/square. The sheet resistance after testing in the third sample is 100Ω/square.

Thus, in the first sample and the second sample, the sheet resistance significantly increases after the test. On the other hand, in the third sample, the increase in sheet resistance after the test is suppressed.

In the first sample and the second sample, the impurity MAI enters the second layer 12, which is thought to reduce the conductivity. For example, impurities enter the polythiophene member 12M included in the second layer 12. This impurity may disturb the alignment of the polythiophene member 12M. It is considered that this reduces the conductivity.

On the other hand, in the third sample, the impurity MAI is considered to be effectively blocked by the third layer 13. It is considered that this suppresses the impurity MAI from entering the second layer 12.

The third layer 13 includes the graphene member 13M. The graphene skeleton of the graphene member 13M is arranged substantially along the X-Y plane, for example (see FIG. 1). As a result, it is considered that the penetration of impurities into the second layer 12 is effectively suppressed in the third layer 13. This suppresses deterioration of electrical resistance (sheet resistance). Embodiments can provide a conductive member capable of obtaining stable characteristics.

In the embodiment, the inclusion of PEDOT and PSS in the second layer 12 stably provides higher electrical conductivity. In the case where the second layer 12 includes PEDOT and PSS, it is considered that the adverse effect on conductivity when impurities enter the second layer 12 is more likely to become apparent. Suppression of change in electrical resistance due to the provision of the third layer 13 is exhibited more effectively.

In the embodiment, when the second layer 12 includes guanidine, for example, deterioration of the metal nanowires 11N can be suppressed more effectively. In the case where the second layer 12 includes guanidine, it is considered that the adverse effect on conductivity when impurities enter the second layer 12 is more likely to become apparent. Suppression of change in electrical resistance due to the provision of the third layer 13 is exhibited more effectively.

In the embodiment, the polythiophene member 12M is preferably neutral (e.g., pH is 5 to 7). For example, the hydrogen ion exponent (pH) of the aqueous solution of the polythiophene member 12M is preferably not less than 5 and not more than 7. As a result, alteration (for example, oxidation) of the metal or the like included in the conductive member 10 is suppressed. For example, alteration (for example, oxidation) of the metal nanowires 11N included in the first layer 11 is effectively suppressed. More stable characteristics can be obtained. For example, the polythiophene member 12M is removed from the conductive member 10, and the pH of the aqueous solution in which the removed polythiophene member 12M is dispersed is, for example, not less than 5 and not more than 7.

As shown in FIG. 1B, a thickness of the first layer 11 along the first direction from the metal nanowires 11N to the third layer 13 is defined as a thickness t1. In the embodiment, the thickness t1 is preferably not less than two times and not more than four times the diameter d1 of the multiple metal nanowires 11N, for example. For example, the sheet resistance of the first layer 11 becomes low because the thickness t1 is twice or more the diameter d1. When the thickness t1 is four times or less the diameter d1, for example, sufficient light transmittance can be obtained.

As shown in FIG. 1B, a thickness of the second layer 12 along the first direction is defined as a thickness t2. In the embodiment, the thickness t2 is preferably not less than 10 nm and not more than 100 nm, for example. When the thickness t2 is 10 nm or more, for example, a uniform film can be easily obtained. When the thickness t2 is 100 nm or less, for example, it is easy to obtain sufficient light transmittance.

As shown in FIG. 1B, a thickness of the third layer 13 along the first direction is defined as a thickness t3. In the embodiment, the thickness t3 is preferably not less than 1 nm and not more than 4 nm, for example. When the thickness t3 is 1 nm or more, for example, a uniform film can be easily obtained. When the thickness t3 is 1 nm or more, for example, the protective effect of the third layer can be easily obtained. When the thickness t3 is 4 nm or less, for example, sufficient light transmittance can be easily obtained.

FIG. 6 is a graph illustrating characteristics of the conductive member.

The horizontal axis of FIG. 6 is the thickness t3 of the third layer 13. The vertical axis is a sheet resistance Rs1. The sheet resistance Rs1 is the sheet resistance after the third layer 13 of the conductive member 10 is brought into contact with impurities. As shown in FIG. 6, when the thickness t3 is 1 nm or more, a low sheet resistance Rs1 can be obtained.

FIGS. 7A and 7B are schematic views illustrating the conductive member.

FIG. 7A illustrates the case of a neutral polythiophene layer (including PSS anions (PSS-) and ammonium cations (N+)). In FIG. 7A, the graphene layer does not interact much with neutral external ions (M+X-) such as MAI. The interfaces of the graphene layers are stable. The graphene layer has high shielding properties. For example, the neutral polythiophene layer hardly corrodes the metal nanowires 11N. For example, nitrogen-substituted graphene substituted with polyethylenimine does not interact well with the ions (PSS- and N+) in the neutral polythiophene layer. In nitrogen-substituted graphene, the interface is stable. Nitrogen-substituted graphene retains ion shielding ability.

FIG. 7B illustrates the case of an acidic polythiophene layer (PSS-H+). In the acidic polythiophene layer, H+ tends to react with basic nitrogen-substituted graphene at the interface. This tends to increase the sheet resistance.

FIG. 8 is a schematic view illustrating a part of the conductive member according to the first embodiment.

As shown in FIG. 8, in at least a part of the graphene member 13M, at least one of multiple carbon atoms included in the graphene skeleton may be substituted with a nitrogen atom. In the graphene member 13M, the graphene skeleton includes a 6-membered carbon ring condensed structure. The graphene skeleton included in the graphene member 13M may include, for example, at least one of a 5-membered ring and a 7-membered ring. At least one group selected from the group consisting of a hydroxyl group, a carboxyl group, and an epoxy group may be bonded to the graphene skeleton included in the graphene member 13M.

FIG. 9 is a schematic view illustrating a part of the conductive member according to the first embodiment.

As shown in FIG. 9, the graphene member 13M may include polyalkyleneimine groups. The polyalkyleneimine groups are bonded to carbon atoms included in the graphene backbone. FIG. 9 illustrates a polyethyleneimine chain as a polyalkyleneimine chain. The number of carbon atoms included in the alkyleneimine unit is preferably not less than 2 and not more than 8, for example. The graphene member 13M preferably includes polyethyleneimine including units having two carbon atoms. The graphene member 13M may include, for example, linear polyalkyleneimine. The graphene member 13M may include, for example, polyalkyleneimine including branched chains. The graphene member 13M may include, for example, polyalkyleneimine having a cyclic structure. n (the number of repeating units) in polyethyleneimine is preferably, for example, not less than 10 and not more than 1000. More preferably, n (the number of repeating units) in polyethyleneimine is, for example, not less than 100 and not more than 300.

In the embodiment, for example, the polythiophene member 12M may include PEDOT (poly (3,4-ethylenedioxythiophene)) (see FIG. 3). The second layer 12 may, for example, include PSS (poly (4-styrenesulfonic acid)) (see FIG. 4).

FIG. 10 is a schematic view illustrating a part of the conductive member according to the first embodiment.

The second layer 12 may include a first compound 12c illustrated in FIG. 10. The first compound 12c includes an ammonium group. In this ammonium group, it is steric. This ammonium group is bulky. By including such a first compound 12c, for example, the pH tends to become neutral when dispersed in water. By including such a first compound 12c, for example, PEDOT is easily arranged. The concentration of the first compound 12c in the second layer 12 is, for example, not less than 0.2 mol and not more than 1 mol with respect to the sulfonic acid group in the PSS.

FIGS. 11A to 11C are schematic views illustrating a part of the conductive member according to the first embodiment.

As shown in FIG. 11A, the first compound 12c may include, for example, a guanine derivative.

As shown in FIG. 11B, the first compound 12c may include, for example, a guanidine derivative.

As shown in FIG. 11C, the first compound 12c may include, for example, an arginine derivative.

The first compound 12c may include at least one selected from the group consisting of guanine derivatives, guanidine derivatives, and arginine derivatives. FIGS. 11A to 11C illustrate unsubstituted guanine, guanidine, and arginine, respectively. In the embodiment, the first compound 12c is preferably unsubstituted guanine, guanidine, and arginine. In the embodiment, when the first compound 12c is each of substituted guanine, guanidine, and arginine, those substituents are preferably alkyl substituted. In the alkyl-substituted compound the number of carbon atoms is preferably not less than 1 and not more than 4.

FIG. 12 is a schematic cross-sectional view illustrating the conductive member according to the first embodiment.

As shown in FIG. 12, the conductive member 10 according to the embodiment may further include a fourth layer 14. Between the first layer 11 and the fourth layer 14 is the second layer 12. Between the second layer 12 and the fourth layer 14 is the third layer 13. The fourth layer 14 includes metal oxide.

The fourth layer 14 includes at least one metal element selected from the group consisting of Sn, Ti, W, Mo and V, and oxygen. The fourth layer 14 is, for example, a SnO₂ layer. The more stable conductive member 10 is obtained by providing the fourth layer 14. A change in sheet resistance is more stably suppressed. The fourth layer 14 may function, for example, as a barrier layer. The fourth layer 14 may function, for example, as a charge injection layer.

For example, a fourth sample further includes the fourth layer 14 in addition to the configuration of the third sample. In the fourth sample, the sheet resistance after testing in which the conductive member 10 is in contact with MAI is about 40Q/square. A lower and more stable sheet resistance is obtained.

A thickness t4 of the fourth layer 14 along the first direction (for example, the Z-axis direction) is preferably not less than 5 nm and not more than 50 nm. When the thickness t4 is 5 nm or more, for example, changes in the sheet resistance can be more stably suppressed. When the thickness t4 is 50 nm or less, for example, the electrical resistance is lowered.

In the embodiment, the surface of the fourth layer 14 may be contacted with an atmosphere including sulfur. This results in lower the sheet resistance. For example, in a fifth sample in which the surface of the fourth layer 14 is brought into contact with an atmosphere including sulfur, the sheet resistance after the test in which the conductive member 10 is brought into contact with MAI is about 30Ω/square.

The sulfur-including atmosphere may include sulfur or sulfur compounds. In the method of contacting with an atmosphere including sulfur, for example, a stacked film including the first to fourth layers 11-14 is contacted with a gas including sulfur or a sulfur compound. In the method of contacting with an atmosphere including sulfur, for example, the stacked film is contacted with a liquid including sulfur or a sulfur compound. For example, at least one of contact with sulfur vapor gas, contact with hydrogen sulfide gas, contact with an aqueous solution of hydrogen sulfide, contact with an aqueous solution of sodium sulfide, and contact with a solution of thioacetamide may be applied.

### (Second embodiment)

The second embodiment relates to an electronic device.

FIGS. 13 and 14 are schematic cross-sectional views illustrating an electronic device according to the second embodiment.

As shown in FIG. 13, an electronic according to the embodiment includes the conductive member 10 according to the first embodiment, a counter electrode 20, and an active layer 30. The active layer 30 is provided between the conductive member 10 and the counter electrode 20. The second layer 12 is provided between the first layer 11 and the active layer 30. The third layer 13 is provided between the second layer 12 and the active layer 30. In this example, the conductive member 10 includes the fourth layer 14. The fourth layer 14 is provided between the third layer 13 and the active layer 30. The active layer 30 includes, for example, a photoelectric conversion layer.

The active layer 30 may include, for example, an ammonium salt illustrated in FIG. 14. The active layer 30 includes, for example, a perovskite material. The perovskite material includes the ammonium salt. The ammonium salt can be, for example, MAI.

In one example, the electronic device 110 is, for example, a solar cell. In the electronic device 110, the conductive member 10 includes the second layer 12 and the third layer 13, so that substances included in the active layer 30 (for example, ammonium salt such as MAI) can be suppressed from entering the second layer 12. The change in the sheet resistance is effectively suppressed. For example, an electronic device with stable characteristics can be provided.

A thickness t30 along the first direction (Z-axis direction) of the active layer 30 is, for example, not less than 100 nm and not more than 1000 nm.

A thickness t20 along the first direction (Z-axis direction) of the counter electrode 20 is, for example, not less than 10 nm and not more than 200 nm. The counter electrode 20 includes at least one selected from the group consisting of Ag, Au, Al and Cu, for example.

### (Third embodiment)

The third embodiment relates to a method for manufacturing the conductive member.

FIGS. 15A to 15C are schematic cross-sectional views illustrating the method for manufacturing the conductive member according to the third embodiment.

As shown in FIG. 15A, the first layer 11 is prepared in the method for manufacturing the conductive member 10 according to the embodiment. The first layer 11 is provided, for example, on the base 10s. The first layer 11 includes the metal nanowires 11N (see FIG. 1).

As shown in FIG. 15B, the second layer 12 is formed on the first layer 11. The second layer 12 includes the polythiophene member 12M (see FIG. 1).

The third layer 13 is formed on the second layer 12, as shown in FIG. 15C. The third layer 13 includes the graphene member 13M (see FIG. 1) including a graphene skeleton.

The first layer 11 can be obtained, for example, by applying a liquid including multiple metal nanowires 11N onto the base 10s by various methods. The liquid is, for example, water or a dispersion including alcohol. Heating may be performed at a temperature of not lower than 80 °C and not higher than 150 °C using a hot plate, hot air, infrared rays, or the like.

The second layer 12 can be obtained, for example, by coating the first layer 11 with a solution including a substance (for example, PEDOT, PSS, guanidine, etc.) for the second layer 12. Heating may be performed at a temperature of not lower than 80 °C and not higher than 150 °C using a hot plate, hot air, infrared rays, or the like.

The third layer 13 can be obtained, for example, by coating the second layer 12 with a solution including a material to be the third layer 13 (for example, graphene including a polyethyleneimine group). The solution includes water, alcohol, or the like. Heating may be performed at a temperature of not lower than 80 °C and not higher than 150 °C using a hot plate, hot air, infrared rays, or the like.

The embodiments may include the following configurations (for example, technical proposals).

### Configuration 1

A conductive member, comprising:
a first layer including a metal nanowire;
a second layer including a polythiophene member; and
a third layer including a graphene member including a graphene skeleton, the second layer being provided between the metal nanowire and the third layer.

### Configuration 2

The conductive member according to Configuration 1, wherein
the polythiophene member is neutral.

### Configuration 3 (being neutral)

The conductive member according to Configuration 1, wherein
a hydrogen ion exponent of an aqueous solution of the polythiophene member is not less than 5 and not more than 7.

### Configuration 4

The conductive member according to any one of Configurations 1 to 3, wherein
a thickness of the third layer along a first direction from the first layer to the third layer is not less than 1 nm and not more than 4 nm.

### Configuration 5

The conductive member according to Configuration 4, wherein
a thickness of the second layer along the first direction is not less than 10 nm and not more than 100 nm.

### Configuration 6

The conductive member according to Configuration 4 or 5, wherein
a thickness of the first layer along the first direction is not less than 2 times and not more than 4 times a diameter of the metal nanowire.

### Configuration 7

The conductive member according to any one of Configurations 1 to 6, wherein
the first layer includes a plurality of the meal nanowires,
at least two of the plurality of nanowires are intertwined,
the first layer has an unevenness, and
the second layer and the third layer are along the unevenness.

### Configuration 8

The conductive member according to any one of Configurations 1 to 6, wherein
the first layer includes a plurality of the meal nanowires,
at least a part of the second layer and at least a part of the third layer are between the plurality of metal nanowires.

### Configuration 9

The conductive member according to any one of Configurations 1 to 8, further comprising:
a base,
the first layer being between the base and the third layer.

### Configuration 10

The conductive member according to any one of Configurations 1 to 9, wherein
in at least a part of the graphene member, at least one of a plurality of carbon atoms included in the graphene skeleton may be substituted with a nitrogen atom.

### Configuration 11

The conductive member according to any one of Configurations 1 to 9, wherein
the graphene member includes polyalkyleneimine groups bonded to a carbon atom included in the graphene backbone.

### Configuration 12

The conductive member according to any one of Configurations 1 to 11, wherein
the polythiophene member includes poly (3,4-ethylenedioxythiophene).

### Configuration 13

The conductive member according to Configuration 12, wherein
the second layer includes poly (4-styrenesulfonic acid).

### Configuration 14

The conductive member according to any one of Configurations 1 to 13, wherein
the second layer further includes a first compound, and
the first compound includes an ammonium group.

### Configuration 15

The conductive member according to Configuration 14, wherein
the first compound includes at least one selected from the group consisting of guanine derivatives, guanidine derivatives, and arginine derivatives.

### Configuration 16

The conductive member according to any one of Configurations 1 to 15, further comprising:
a fourth layer,
the second layer being between the first layer and the fourth layer,
the third layer being between the second layer and the fourth layer, and
the fourth layer including a metal oxide.

### Configuration 17

An electronic device, comprising:
the conductive member according to any one of Configurations 1 to 16;
a counter electrode; and
an active layer provided between the conductive member and the counter electrode,
the second layer being provided between the first layer and the active layer.

### Configuration 18

The electronic device according to Configuration 17, wherein
the active layer includes a photoelectric conversion layer.

### Configuration 19

The electronic device according to Configuration 17 or 18, wherein
the active layer includes an ammonium salt.

### Configuration 20

A method for manufacturing a conductive member, the method including:
forming a second layer including a polythiophene member on a first layer including a metal nanowire; and
forming a third layer including a graphene member including a graphene skeleton on the second layer.

According to embodiments, it is possible to provide a conductive member, an electronic device, and a method for manufacturing the conductive member, in which stable characteristics can be obtained.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in conductive members and electronic devices such as first to third layers, bases, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all conductive members, electronic devices, and methods for manufacturing conductive members practicable by an appropriate design modification by one skilled in the art based on the conductive member, the electronic devices, and the methods for manufacturing conductive members described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

### [Explanation of Letters or Numerals]

10: conductive member, 10s: base, 11 to 14: first to fourth layer, 11N: metal nanowire, lldp: unevenness, 12M: polythiophene member, 12c: first compound, 13M: graphene member, 20: counter electrode, 30: active layer, 110: electronic device, L1: length, Rs1: sheet resistance, d1: diameter, t1 to t4, t20, t30: thickness

## Claims

1. A conductive member, comprising:
a first layer including a metal nanowire;
a second layer including a polythiophene member; and
a third layer including a graphene member including a graphene skeleton, the second layer being provided between the metal nanowire and the third layer.

2. The conductive member according to claim 1, wherein
the polythiophene member is neutral.

3. The conductive member according to claim 1, wherein
a hydrogen ion exponent of an aqueous solution of the polythiophene member is not less than 5 and not more than 7.

4. The conductive member according to claim 1, wherein
a thickness of the third layer along a first direction from the first layer to the third layer is not less than 1 nm and not more than 4 nm.

5. The conductive member according to claim 4, wherein
a thickness of the second layer along the first direction is not less than 10 nm and not more than 100 nm.

6. The conductive member according to claim 4, wherein
a thickness of the first layer along the first direction is not less than 2 times and not more than 4 times a diameter of the metal nanowire.

7. The conductive member according to claim 1, wherein
the first layer includes a plurality of the meal nanowires,
at least two of the plurality of nanowires are intertwined,
the first layer has an unevenness, and
the second layer and the third layer are along the unevenness.

8. The conductive member according to claim 1, wherein
the first layer includes a plurality of the meal nanowires,
at least a part of the second layer and at least a part of the third layer are between the plurality of metal nanowires.

9. The conductive member according to claim 1, further comprising:
a base,
the first layer being between the base and the third layer.

10. The conductive member according to claim 1, wherein
in at least a part of the graphene member, at least one of a plurality of carbon atoms included in the graphene skeleton may be substituted with a nitrogen atom.

11. The conductive member according to claim 1, wherein
the graphene member includes polyalkyleneimine groups bonded to a carbon atom included in the graphene backbone.

12. The conductive member according to claim 1, wherein
the polythiophene member includes poly (3,4-ethylenedioxythiophene).

13. The conductive member according to claim 12, wherein
the second layer includes poly (4-styrenesulfonic acid).

14. The conductive member according to claim 1, wherein
the second layer further includes a first compound, and
the first compound includes an ammonium group.

15. The conductive member according to claim 14, wherein
the first compound includes at least one selected from the group consisting of guanine derivatives, guanidine derivatives, and arginine derivatives.

16. The conductive member according to claim1, further comprising:
a fourth layer,
the second layer being between the first layer and the fourth layer,
the third layer being between the second layer and the fourth layer, and
the fourth layer including a metal oxide.

17. An electronic device, comprising:
the conductive member according to claim 1;
a counter electrode; and
an active layer provided between the conductive member and the counter electrode,
the second layer being provided between the first layer and the active layer.

18. The electronic device according to claim 17, wherein
the active layer includes a photoelectric conversion layer.

19. The electronic device according to claim 17, wherein
the active layer includes an ammonium salt.

20. A method for manufacturing a conductive member, the method including:
forming a second layer including a polythiophene member on a first layer including a metal nanowire; and
forming a third layer including a graphene member including a graphene skeleton on the second layer.
